# FASCICULE DE BREVET EUROPEEN

(11) **EP 2 587 539 B1**
(45) Date de publication et mention de la délivrance du brevet: **16.07.2014**
(21) Numéro de dépôt: 12190041.9
(22) Date de dépôt: 25.10.2012
(51) Int. Cl.: H01L 31/18, H01L 27/146

(54) **Imageur CMOS UTBB**
CMOS-UTBB-Bildaufnehmer
UTTB CMOS imager

(30) Priorité: 28.10.2011 FR 1159802
(43) Date de publication de la demande: 01.05.2013
(73) Titulaire: Commissariat à l'Énergie Atomique et aux Énergies Alternatives, 75015 Paris (FR)
(72) Inventeur: Grenouillet, Laurent, 38140 RIVES (FR); Vinet, Maud, 38140 RIVES (FR)
(74) Mandataire: Ilgart, Jean-Christophe

(56) Documents cités:
- WO-A1-2006/043105
- WO-A1-2007/001146
- US-A- 4 954 895
- US-A1- 2006 125 038

## Description

### DOMAINE TECHNIQUE ET ART ANTÉRIEUR

La présente invention se rapporte au domaine de la photo-détection et de l'imagerie et concerne la mise en oeuvre d'un dispositif imageur amélioré en termes d'agencement et doté d'un élément de photo-détection et d'un élément de lecture associés dans lequel la transmission de signal entre l'élément de détection et l'élément de lecture est simplifiée.

Un dispositif capteur d'image peut être formé d'une matrice d'éléments photo-détecteurs connectée et assemblée avec un circuit électronique de lecture par des éléments de connexion. Selon un exemple de réalisation connu, ces éléments de connexion peuvent être des billes d'Indium. Un tel assemblage nécessite un alignement précis entre le circuit de lecture et les éléments photo-détecteurs et pose des problèmes d'encombrement.

Dans un dispositif capteur d'image de type CMOS, les pixels sont généralement formés d'un élément photo-détecteur tel qu'une photodiode par exemple de type communément appelée « pinned », et d'un élément de lecture, par exemple sous forme d'un convertisseur de charge/tension.

Un exemple de capteur d'image CMOS est donné dans le document US 6 967 120 B2 et comporte un transistor de lecture dont la grille est accolée à la photodiode, le transistor étant réalisé sur une même face d'un substrat que la photodiode.

Dans ce type de dispositif, le transistor de lecture est utilisé pour collecter des électrons excédentaires générés par la lumière détectée. Pendant ce transfert, une partie des électrons peut se recombiner, ce qui diminue le rendement de collection.

Dans un tel capteur, le transistor de lecture occupe par ailleurs sur le substrat un espace qui n'est pas directement utilisé pour la conversion de la lumière en électrons.

Le document WO 2006/043105 A1 présente un dispositif capteur d'image comprenant un transistor de lecture reposant sur un substrat semi-conducteur sur isolant, le substrat comportant une couche de support semi-conductrice dans laquelle une jonction est réalisée et qui permet de produire des charges lorsque la couche de support est illuminée. Des charges générées au niveau de cette jonction sont collectées par le biais d'une interconnexion métallique prévue entre le transistor de lecture et la jonction.

Le document US 4 954 895 présente quant à lui un dispositif capteur d'image doté d'un premier transistor dont le canal est situé dans une couche semi-conductrice dopée P reposant sur une couche semi-conductrice dopée N avec laquelle elle réalise une jonction. Lorsque cette jonction est illuminée, des charges sont produites, collectées au niveau du drain du premier transistor et transmises à un transistor de commutation dont la zone de drain vient en contact avec celle du premier transistor.

Il se pose le problème de mettre en oeuvre une nouvelle structure de capteur d'image améliorée vis-à-vis des inconvénients évoqués ci-dessus, notamment en termes d'encombrement.

### EXPOSÉ DE L'INVENTION

La présente invention prévoit tout d'abord un dispositif capteur d'image, comme définit dans la revendication 1, et comprenant au moins un transistor reposant sur un substrat comprenant une fine couche semi-conductrice dans laquelle une zone de canal dudit transistor est prévue, une couche isolante séparant la fine couche semi-conductrice d'une couche de support semi-conductrice, la couche de support semi-conductrice comprenant au moins une zone de photo-détection comportant au moins une région dopée P et au moins une région dopée N formant une jonction, la jonction étant disposée en regard de la zone de canal dudit transistor.

Le matériau à base duquel la couche isolante est formée, ainsi que l'épaisseur cette couche isolante, sont prévues de sorte qu'un couplage capacitif peut être établi entre la zone de photo-détection et la zone de canal dudit transistor.

Ainsi, un rayonnement lumineux incident sur la zone de photo-détection engendre un signal de détection transmis par couplage capacitif audit transistor.

Un tel dispositif a un agencement amélioré et en particulier un encombrement limité par rapport aux dispositifs dans lequel un transistor de lecture et une zone de photo-détection sont juxtaposés.

Par rapport à un dispositif suivant l'art antérieur dans lequel un transistor de lecture et une zone de photo-détection sont juxtaposés, le dispositif suivant l'invention permet, pour un substrat de même taille, de dédier une surface plus importante à la photo-détection.

Avec un dispositif suivant l'invention toute la surface de la zone photosensible sur laquelle repose le transistor peut être utilisée pour réaliser une détection de rayonnement lumineux, contrairement à un capteur CMOS suivant l'art antérieur pour lequel une partie d'un élément de détection élémentaire est généralement occupée par au moins un transistor de lecture.

Dans le dispositif suivant l'invention, une connectique dédiée entre la zone photosensible et un transistor de lecture n'est pas nécessaire, ce qui peut faciliter notamment la réalisation du dispositif et en particulier permet de s'affranchir de problèmes d'état de surface, de décollement, de contrainte mécanique.

Ainsi, le dispositif peut être prévu de sorte que le transistor et la zone photosensible sont couplés mais ne sont pas reliés par le biais d'une connexion électrique. Dans ce cas, la portion de couche isolante séparant le transistor et la zone sensible est continue, sans qu'un élément de connexion ne la traverse.

Selon l'invention, un rayonnement lumineux incident sur la zone de photo-détection induit un changement de la tension de seuil dudit transistor.

Pour cela, la couche isolante peut être prévue avec une épaisseur qui peut être inférieure ou égale à 25 nanomètres ou inférieure ou égale à 10 nanomètres.

La fine couche semi-conductrice peut avoir quant à elle une épaisseur inférieure à 800 nm et avantageusement entre 5 nm et 100 nm.

La zone de photo-détection peut avoir une épaisseur inférieure à 1 micromètre.

Selon une possibilité de mise en oeuvre, la jonction est une jonction P-I-N.

Une jonction PIN permet d'obtenir une zone de charge d'espace d'épaisseur plus importante et ainsi d'augmenter l'épaisseur de la zone de collection efficace des photons. Quand les photons sont absorbés dans l'épaisseur correspondant à cette zone de charge d'espace, les paires électrons-trous photo-générées sont efficacement dissociés, ce qui maximise la tension induite aux bornes de la photodiode.

La zone photosensible et la fine couche semi-conductrice peuvent être à base de matériaux semi-conducteurs différents. Le matériau constituant la couche de photo-détection peut être ainsi choisi en fonction de la longueur d'onde à détecter, tandis que le matériau dans lequel la zone de canal du transistor est réalisée est choisi de manière à permettre de conférer à ce dernier des performances électriques optimales.

Selon un autre aspect, la présente invention concerne également un procédé de réalisation d'un dispositif capteur d'image, comme décrit dans la revendication 7, comprenant des étapes de :
- réalisation d'un transistor reposant sur un substrat, le substrat comprenant une couche isolante et une fine couche semi-conductrice dans laquelle une zone de canal dudit transistor est réalisée,
- assemblage d'une couche de support semi-conductrice destinée à former une zone de photo-détection comprenant une jonction en regard de la zone de canal dudit transistor.

Un tel assemblage peut être réalisé sans nécessiter un alignement précis.

Un tel assemblage permet de mettre en oeuvre un dispositif capteur d'image comprenant une couche de support dopée préalablement et éventuellement de mettre en oeuvre une couche de support à base d'un matériau différent de celui de la fine couche semi-conductrice dans laquelle le canal du transistor est réalisé.

Un tel assemblage permet également de mettre en oeuvre un dispositif capteur d'image comprenant une couche de support d'épaisseur réduite.

Le matériau à base duquel la couche isolante est formée, ainsi que l'épaisseur cette couche isolante, sont prévues de sorte qu'un couplage capacitif peut être établi entre la zone de photo-détection et la zone de canal dudit transistor.

L'assemblage peut être effectué par collage moléculaire de la couche isolante avec une autre couche isolante recouvrant ladite couche de support.

Un tel assemblage permet de mettre en oeuvre une zone de photo-détection à base de matériaux semi-conducteurs tels que l'InGaAs, ou l'InSb, ou le GaN, ou le CdHgTe, et qui contrairement à un matériau semi-conducteur tel que le Si sont difficiles à mettre sous forme de plaques de tailles importantes.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de dispositif capteur d'image suivant l'invention doté d'une zone photosensible comportant une jonction disposée en regard du canal d'un transistor de détection reposant sur une couche isolante,
- la figure 2 illustre un exemple de dispositif capteur d'image suivant l'invention, doté d'une zone photosensible comprenant une jonction PIN,
- les figures 3A-3B illustrent un phénomène de couplage dans un dispositif capteur d'image suivant l'invention, entre une zone photosensible et une zone semi-conductrice de canal d'un transistor de détection,
- la figure 4 illustre un exemple de dispositif capteur d'image suivant l'invention, doté d'un transistor de détection dont une électrode est mise au potentiel d'une zone photosensible disposée en regard dudit transistor,
- les figures 5A-5H illustrent un exemple de procédé de réalisation d'un dispositif capteur d'image suivant l'invention comportant au moins une zone photosensible disposée en regard du canal d'au moins un transistor de détection reposant sur une couche isolante,
- la figure 6 illustre un exemple de dispositif capteur d'image suivant l'invention doté de zones de contact qui peuvent être à base d'ITO,
- la figure 7 illustre un exemple de dispositif capteur d'image suivant l'invention doté de transistors d'un circuit de lecture placés dans un empilement entre des transistors de détection du type de celui donné sur les figures 1 à 3, et des niveaux métalliques d'interconnexion.
- La figure 8 illustre une variation de tension de seuil sur des transistors de type N et de type P ayant un agencement du type de celui de la figure 2 et soumis à un éclairement variable.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

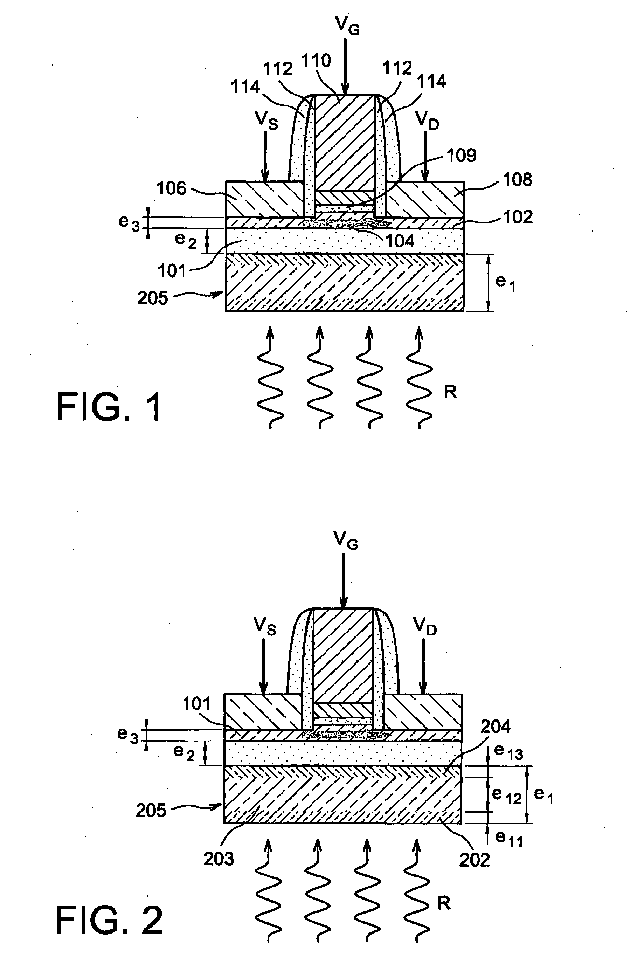

Un exemple de cellule élémentaire également appelée « pixel » d'un dispositif capteur d'image suivant l'invention va à présent être décrit en liaison avec les figures 1, 2 et 3.

Ce pixel comprend une zone photo-sensible 205 formée d'au moins deux zones dopées superposées réalisant une jonction de diode, par exemple une jonction de type PN.

L'épaisseur e₁ de la zone photosensible et exposée au rayonnement, peut être prévue supérieure à 1/a, a étant le coefficient d'absorption linéique du matériau de la zone photosensible, ceci afin de maximiser les absorptions de photons dans la partie photosensible, et en particulier dans la zone de charge d'espace.

L'épaisseur e₁ de la zone photosensible peut être par exemple comprise entre 100 nm et 10 µm par exemple de l'ordre de 1 µm.

La zone photo-détectrice peut avoir une surface par exemple de l'ordre du µm² pour une détection de longueur d'onde par exemple de l'ordre du micromètre.

Dans l'exemple donné sur la figure 2, la zone photosensible 205 est sous forme d'une diode PIN et comprend une première zone 202 dopée selon un dopage d'un premier type, par exemple de type N, qui peut être dévoilée ou découverte.

La première zone dopée 202 a une épaisseur e₁₁ qui peut être prévue inférieure à 1/a et par exemple comprise entre 2 nm et 200 nm ou de l'ordre de 100 nanomètres.

La première zone dopée 202 est surmontée d'une zone semi-conductrice intrinsèque 203 ou non dopée, ayant une épaisseur e₁₂ qui peut être comprise par exemple entre 100 nm et un ou plusieurs microns, elle-même surmontée d'une deuxième zone dopée 204 selon un dopage d'un deuxième type, par exemple de type P. La deuxième zone dopée 204 a, quant à elle, une épaisseur e₁₃ qui peut être comprise par exemple entre 100 nm et 1 µm.

La zone photosensible 205 est à base d'un matériau choisi en fonction de la longueur d'onde ou de la gamme de longueurs d'ondes que l'on souhaite détecter. La zone photosensible 205 peut être formée par exemple d'un ou plusieurs matériau(x) semi-conducteur(s) parmi les matériaux suivants : Si, Ge, InGaAs, InSb, CdHgTe, GaN.

Dans un cas, par exemple, où le capteur est prévu pour détecter un rayonnement situé dans le domaine UV, le matériau de la zone photosensible 205 peut être un matériau semi-conducteur III-V, par exemple à base de GaN ou d'AlGaN.

Dans un autre cas, par exemple, où le capteur est destiné à détecter un rayonnement ayant une longueur d'onde dans une gamme inférieure à 1.1 µm, la zone photosensible peut être par exemple à base de silicium.

Si l'on souhaite détecter un rayonnement ayant une longueur d'onde dans une gamme comprise entre 1.3 µm et 1.55 µm, le matériau de la zone photosensible peut être par exemple prévu à base de Germanium ou d'un matériau III-V tel que de l'InGaAs.

Selon un autre exemple, pour détecter un rayonnement ayant une longueur d'onde dans une gamme comprise entre 3 µm et 5 µm ou entre 8 µm et 12 µm, un matériau II-VI, par exemple à base de CdHgTe peut être utilisé.

La zone photosensible 205 forme ainsi une couche de support d'un substrat de type semi-conducteur sur isolant et est surmontée par une fine couche isolante 101. Cette fine couche isolante 101 peut être par exemple à base de SiO₂. La fine couche isolante 101 peut être prévue avec une épaisseur e₂ choisie suffisamment faible pour qu'une tension photo-générée sur sa face arrière puisse induire une tension correspondante par phénomène de couplage capacitif sur sa face avant.

L'épaisseur e₂ₘₐₓ maximale de la fine couche isolante 101, peut être en particulier prévue de manière à permettre un couplage capacitif entre la zone photosensible 205 et une fine couche semi-conductrice 102 en contact avec cette dernière. L'épaisseur e₂ de la fine couche isolante est de préférence inférieure à 300 nm et comprise par exemple entre 2 nm et 300 nm, par exemple inférieure ou égale à 25 nanomètres ou inférieure ou égale à 10 nanomètres.

A titre d'exemple, une variation de tension de seuil du transistor T peut être de l'ordre de 80 mV lorsqu'on applique un potentiel de 1V sur la face arrière avec une couche isolante 101 à base de SiO₂ d'épaisseur e₂ de l'ordre de 25 nm et une fine couche semi-conductrice 102 de silicium de 7 nm.

La fine couche semi-conductrice 103 surmontant la couche isolante 101 peut quant à elle être prévue avec une épaisseur e₃ inférieure à 800 nm correspondant à l'épaisseur de déplétion d'un substrat non dopé pour une tension de grille de 0V, et en particulier comprise par exemple entre 5 nm et 100 nanomètres. Une épaisseur inférieure à 100 nm permet d'obtenir une couche complètement déplétée.

La mise en oeuvre de couches semi-conductrices 103 et 205 et d'une couche isolante 101 de faibles épaisseurs peut permettre de réaliser un capteur d'image avec une épaisseur totale suffisamment faible pour qu'il soit flexible.

Dans la fine couche semi-conductrice 102, une zone de canal 104 d'un transistor T est formée. La fine couche 102 peut être à base d'un matériau semi-conducteur différent de celui de la zone photosensible.

La fine couche 102 peut être, par exemple, à base de silicium, tandis que la zone photosensible 205 est formée d'un autre matériau semi-conducteur choisi en fonction du rayonnement lumineux à détecter. Le canal du transistor T peut être complètement déserté. Le transistor T ainsi réalisé peut être de type UTBB (UTBB pour « Ultra Thin BOX and Body »).

Ce transistor comporte en outre une zone de diélectrique 109 de grille, ainsi qu'une électrode de grille 110 reposant sur la zone diélectrique 109.

La zone de canal 104 et la grille 110 du transistor T sont situées en regard d'une région de la zone photosensible 205. Dans le cas, par exemple, où la grille 110 a une dimension critique ou une longueur par exemple de l'ordre de 30 nm, la fine couche semi-conductrice 102 peut être prévue par exemple entre 5 nanomètres et 7 nanomètres.

La grille 110 est entourée de part et d'autre de zones isolantes formant des premiers espaceurs 112. Les premiers espaceurs 112 sont partiellement enterrés dans la zone active du transistor T et en contact avec des flancs de la grille 110, tandis que d'autres zones isolantes formant des deuxièmes espaceurs 114, reposent sur la zone active du transistor T et sont disposés contre les premiers espaceurs 112.

Lorsque la zone photo-sensible 205 ou photo-détectrice est soumise au rayonnement lumineux R, cela peut entrainer une modification de la tension de seuil V_{T} du transistor T, l'amplitude de cette modification pouvant permettre de traduire une détection d'un flux donné de photons associé à ce rayonnement lumineux. Une détection de certains rayonnements lumineux pénétrant par la face avant du dispositif, c'est-à-dire la face où se situe la grille 110, est possible.

Un circuit de lecture peut par exemple être mis en oeuvre au niveau du ou des transistors servant à la détection. Les transistors du circuit de lecture sont de préférence prévus de sorte que leur tension de seuil, contrairement au transistor T, soit insensible au flux lumineux. Pour ce faire, on peut par exemple, mettre en oeuvre ces transistors du circuit de lecture de sorte qu'ils aient une couche isolante 101 plus épaisse ou alors une épaisseur de canal plus importante ou un dopage qui ne le rende pas complètement déserté.

Selon une possibilité de mise en oeuvre, un mode de détection binaire peut être réalisé avec un capteur suivant l'invention. Ainsi, le dispositif capteur d'image peut être prévu pour que, lorsqu'il n'y a pas de rayonnement lumineux à détecter, la tension de seuil V_{T} du transistor T est égale à une valeur Vt1.

Lorsque le capteur reçoit un rayonnement lumineux R, une modification de la polarisation du transistor au niveau de son plan de masse induit une modification de la tension de seuil du transistor égale à une autre valeur Vt2 = Vt1 + ΔVt ou Vt2 = Vt1 - ΔVt, avec ΔVt non nul.

Le transistor peut donc être en état bloqué également appelé « OFF » lorsqu'il n'y a pas de flux de photons à détecter et en état passant ou « ON » lorsqu'il y a un flux de photons à détecter.

Lorsque le dispositif capteur d'image est en fonctionnement, les tensions de polarisation VD et VG respectivement prévues sur la zone de drain et sur la grille du transistor T peuvent être de l'ordre du volt.

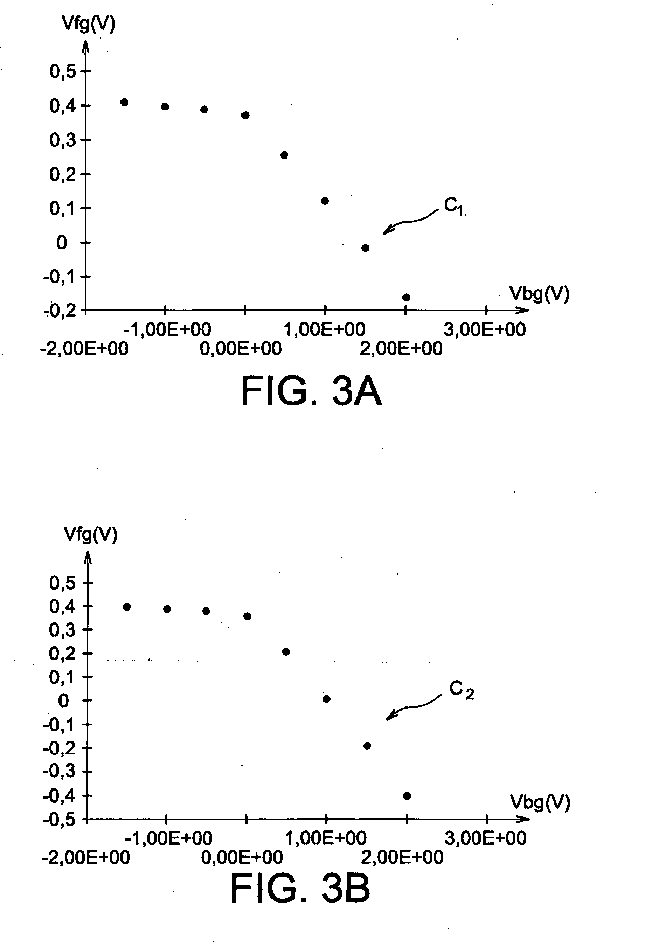

La figure 3A illustre, pour un exemple de dispositif mis en oeuvre suivant l'invention et par l'intermédiaire d'une courbe C₁, la dépendance d'une tension Vfg prise en face avant de ce dispositif au niveau de la fine couche semi-conductrice 103 vis-à-vis du potentiel Vbg en face arrière de ce dispositif au niveau de la zone photosensible 205, lorsque la fine couche semi-conductrice 103 est à base de silicium et a une épaisseur e₃ de l'ordre de 10 nm, que la couche isolante 101 est une couche de BOX d'épaisseur e₂ de l'ordre de 5 nm. Avec un tel dispositif une sensibilité de 260 mV/V peut être obtenue.

Sur la figure 3B une courbe C₂ illustre la dépendance de la tension Vfg prise en face avant vis-à-vis du potentiel Vbg pris en face arrière, cette fois pour un dispositif doté d'une fine couche semi-conductrice 103 à base de silicium et d'épaisseur e₃ de l'ordre de 20nm, et une couche isolante 101 de BOX d'épaisseur e₂ de l'ordre de 25 nm. Avec un tel dispositif une sensibilité de 350 mV/V peut être obtenue.

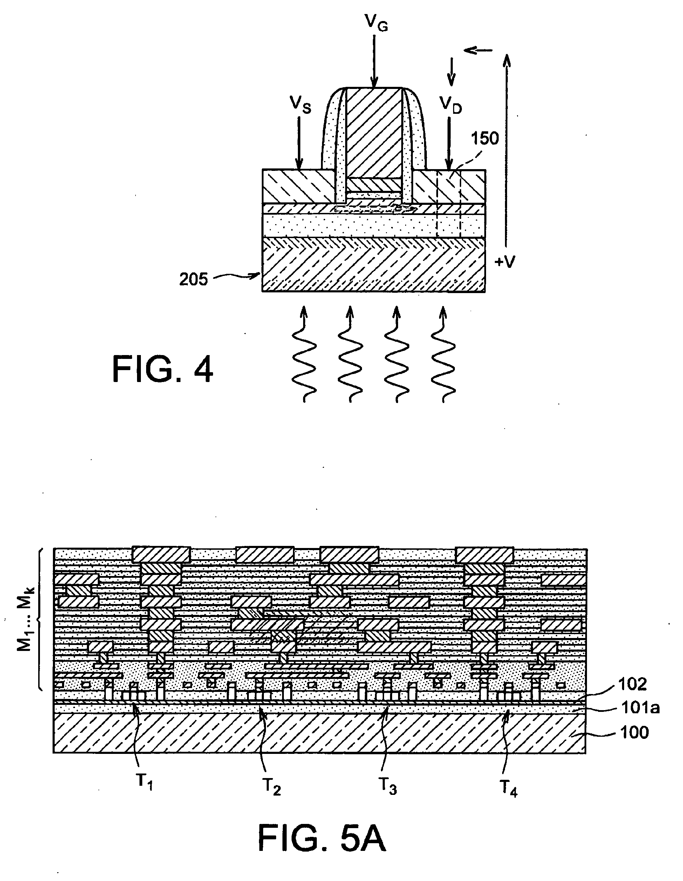

La figure 4 illustre un principe de détection particulier dans lequel un potentiel donné +V généré au niveau de la zone photosensible 205 par un rayonnement lumineux arrivant par la face opposée à celle où se trouve la grille 110 du transistor T, est appliqué à l'une des électrodes du transistor T, par exemple l'électrode de drain 108 pour en modifier ses caractéristiques électriques.

Pour ce mode de réalisation, un élément de connexion 150 peut être prévu par exemple entre le drain et la zone photosensible.

Un procédé de réalisation d'un dispositif capteur d'image suivant l'invention, va à présent être décrit en liaison avec les figures 5A-5H.

On réalise tout d'abord un ou plusieurs transistors T₁, T₂, T₃, T₄ sur un substrat de type semi-conducteur sur isolant, par exemple de type SOI (SOI pour « Silicon on Insulator » ou silicium sur isolant) comprenant une couche de support 100 sacrificielle, une fine couche isolante 101a reposant sur la couche de support 100, et une fine couche semi-conductrice 102 reposant sur la couche isolante 101a.

Les transistors T₁, T₂, T₃, T₄ peuvent être réalisés selon un procédé CMOS et une filière de type UTBB, c'est à dire avec des couches 101a et 102 de très faible épaisseur, en particulier une couche isolante 101a inférieure ou égale à 25 nanomètres et une fine couche semi-conductrice 102 inférieure à 10 nanomètres.

La fine couche isolante 101, peut être par exemple une couche d'oxyde de silicium enterrée prévue avec une épaisseur e₂ comprise par exemple inférieure ou égale à 25 nanomètres ou inférieure ou égale à 10 nanomètres. La fine couche semi-conductrice 102 est quant à elle prévue avec une épaisseur e₃ comprise par exemple entre 5 et 10 nanomètres, par exemple de l'ordre de 6 nanomètres.

Certains des transistors T₁, T₂, T₃, T₄, peuvent avoir des tensions de seuil V_{T} respectives différentes suivant qu'ils sont ou non adaptés à la photo-détection. Plusieurs niveaux M₁,..., Mₖ métalliques d'interconnexion peuvent être ensuite formés dans un empilement de couches isolantes surmontant les transistors T₁,...,T₄ (figure 5A).

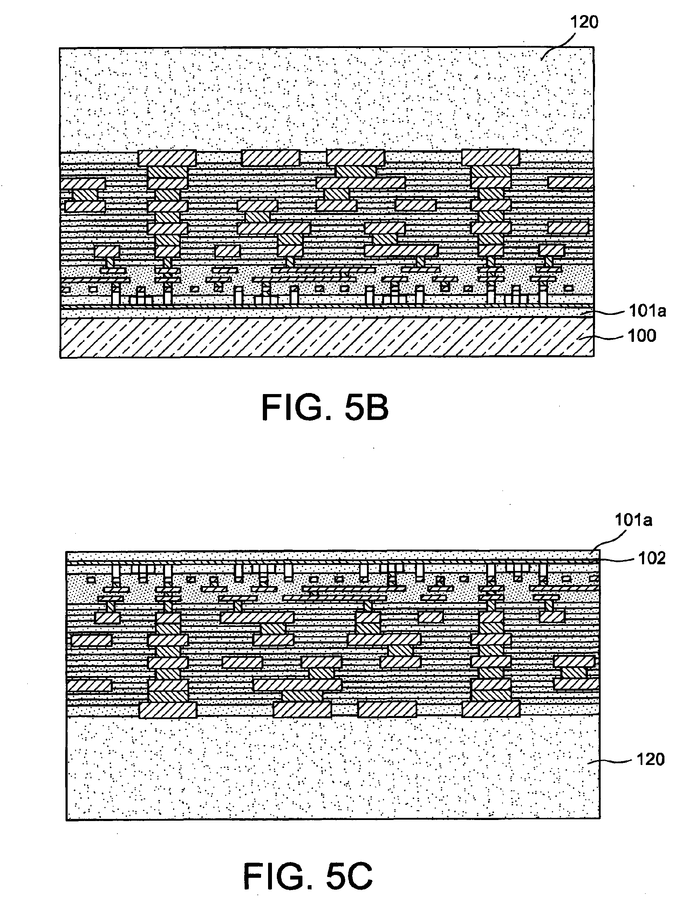

Ensuite, on forme une couche poignée 120 qui peut être par exemple à base d'un matériau polymère ou une autre plaque de silicium collée tête bêche avec la plaque CMOS. La couche poignée 120 permet une préhension du circuit en cours de réalisation. Cette couche poignée 120 peut être éventuellement formée par collage moléculaire d'une plaque sur le dessus du circuit (figure 5B).

Ensuite, on effectue un retrait de la couche de support sacrificielle 100. Ce retrait peut être réalisé par exemple par un procédé de polissage communément appelé de « grinding » ou rodage, dans lequel une surface plane en rotation composée de matériau abrasif retire du matériau 100 de manière mécanique, et par une gravure chimique par exemple à base de TMAH (TMAH pour « tetra-methyl ammonium hydroxide ») en particulier lorsque la couche de support 100 sacrificielle est à base de Si. Un arrêt de gravure est réalisé sur la fine couche isolante 102 (figure 5C).

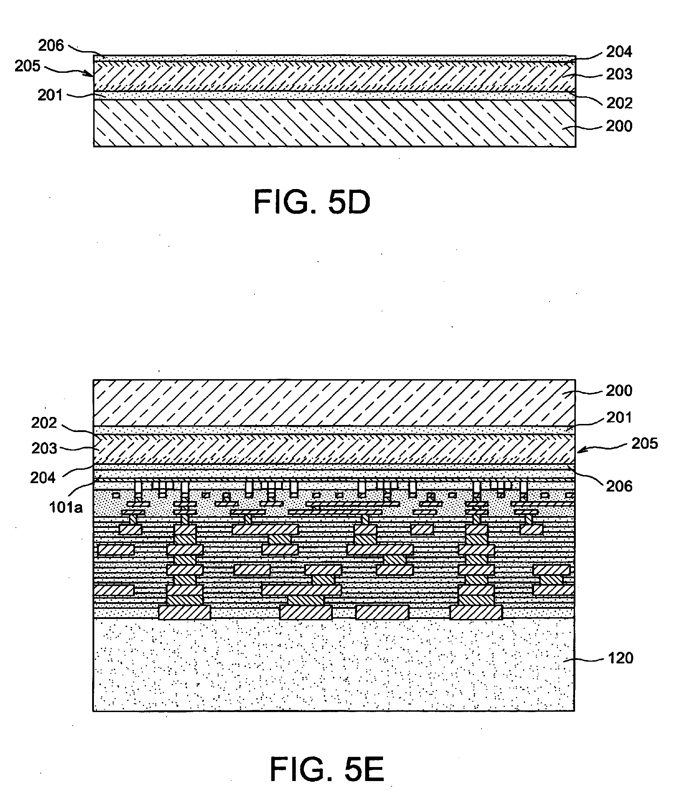

La zone photo-sensible 205 peut, quant à elle, être formée indépendamment sur une autre plaque ou un autre support sur lequel un empilement photo-détecteur est réalisé. Un empilement formé par exemple d'une couche 202 de Ge dopé N recouverte par, et en contact avec, une couche 203 de Ge non dopé, cette couche 203 étant recouverte et en contact avec, une couche 204 de Ge dopé P en pleine plaque sur un substrat de type GeOl, peut être réalisé. Cet autre substrat comprend une couche de support 200 recouvert par une couche isolante 201, par exemple à base de SiO₂. Après avoir réalisé la couche 204 de Ge dopé P, on peut former, par exemple par dépôt, une fine couche isolante 206, qui peut être par exemple à base de SiO₂ et est destinée à servir de couche de collage (figure 5D).

Un collage, par exemple un collage direct SiO₂-SiO₂ de la couche 206 avec la fine couche isolante 101a est ensuite réalisé afin d'assembler le circuit comprenant les transistors T₁,...,T₄ avec la zone photosensible 205 (figure 5E).

Un retrait de la couche de support 200 de l'empilement photo-détecteur avec arrêt sur la couche isolante 201 peut être ensuite effectué. Un arrêt sur la couche isolante 201 permet de préserver toutes les couches actives. Cette couche isolante 201 peut être ensuite retirée afin de dévoiler la zone dopée 202.

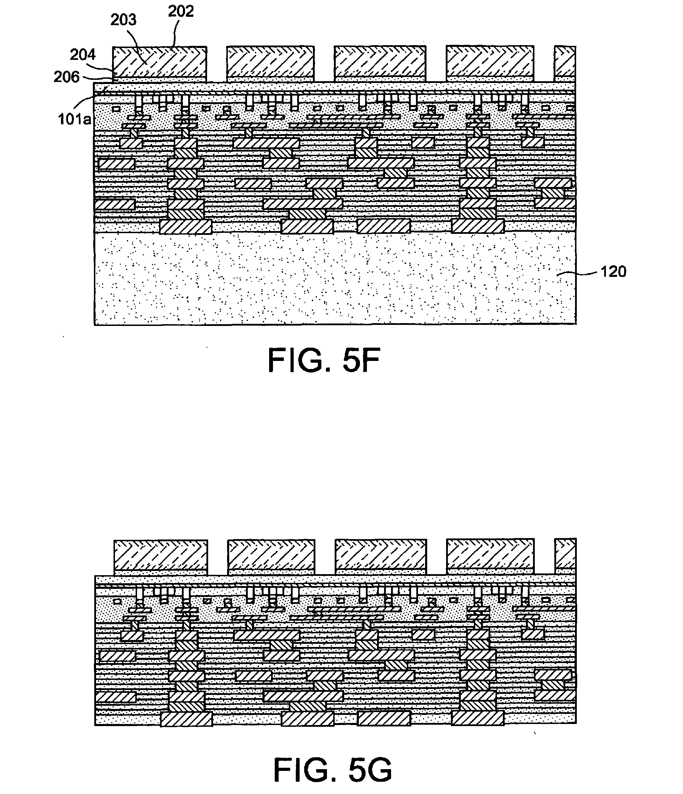

Ensuite, on peut effectuer une gravure de la zone photosensible afin de former plusieurs zones photosensibles distinctes correspondant chacune à une cellule élémentaire ou à un pixel. Une délimitation géométrique des pixels ou cellules du dispositif capteur d'image est ainsi réalisée. Le dispositif capteur d'image est ainsi prévu avec une pluralité de pixels ou de cellules élémentaires (figure 5F).

Un retrait de la couche poignée 120 peut être ensuite effectué (figure 5G). Afin de faciliter ce retrait, une découpe préalable de cette couche 120 peut être prévue.

Dans le cas où l'épaisseur totale du capteur d'image est faible, on peut éventuellement déposer un matériau transparent avant le retrait de la couche poignée 120.

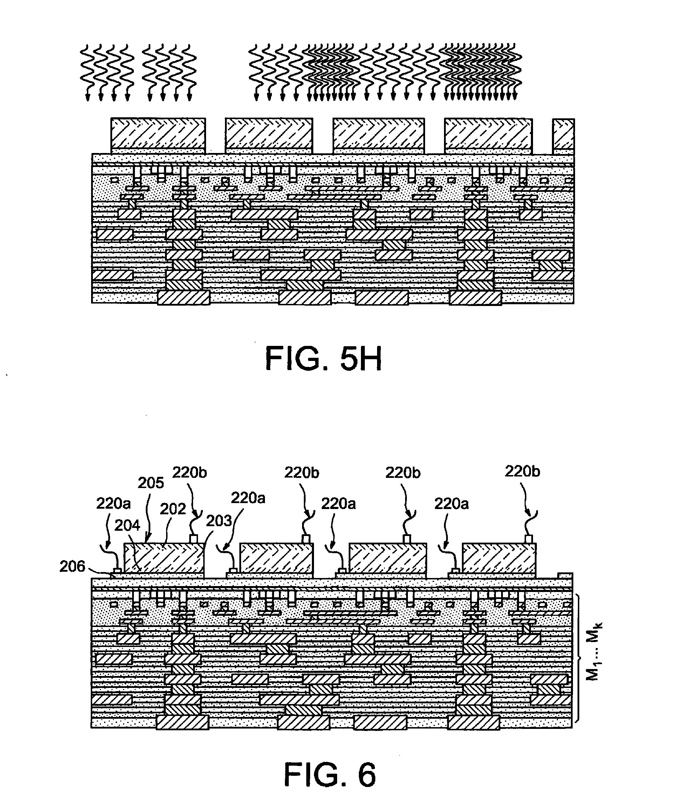

Puis, on peut réaliser un test du dispositif capteur d'image (figure 5H). Selon une variante de réalisation du procédé, au lieu de réaliser l'empilement 202-203-204 photo-détecteur avec une hétéro-structure de type P-I-N préalablement épitaxiée, on peut former par exemple par collage, une couche à base de matériau semi-conducteur non dopé et doper ensuite ce matériau, par exemple par implantation ionique, puis de réaliser un recuit des dopants à des températures compatibles avec un procédé CMOS, ce afin de réaliser une jonction P-N.

Sur la figure 6, une réalisation de contacts 220a, 220b sur chaque pixel est illustrée, un premier contact 220a étant prévu sur la zone 204, un deuxième contact 220b étant prévu sur la zone 202 de l'empilement photosensible. Ces contacts peuvent être réalisés à base d'un matériau transparent tel que de l'ITO (ITO pour « Indium Tin Oxide »).

Selon une autre variante (non représentée), des contacts communs à un ensemble de pixels peuvent être également réalisés.

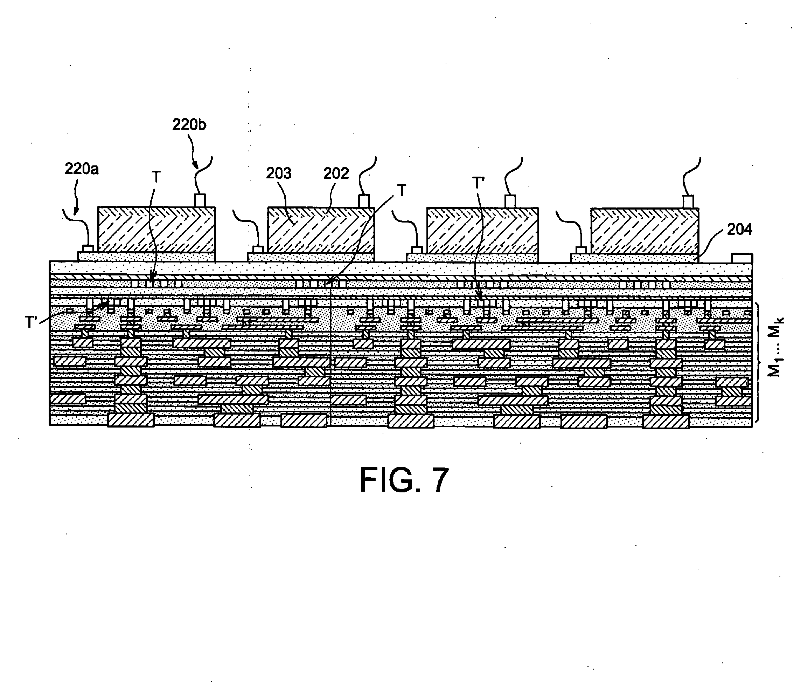

Sur la figure 7 un autre exemple de dispositif microélectronique détecteur de rayonnement lumineux suivant l'invention est donné.

Dans cet exemple, des transistors T' d'un circuit de lecture sont prévus entre les transistors photo-détecteurs T du type de celui décrit précédemment en liaison avec les figures 1 à 3 et des niveaux métalliques d'interconnexion M₁,...,Mₖ.

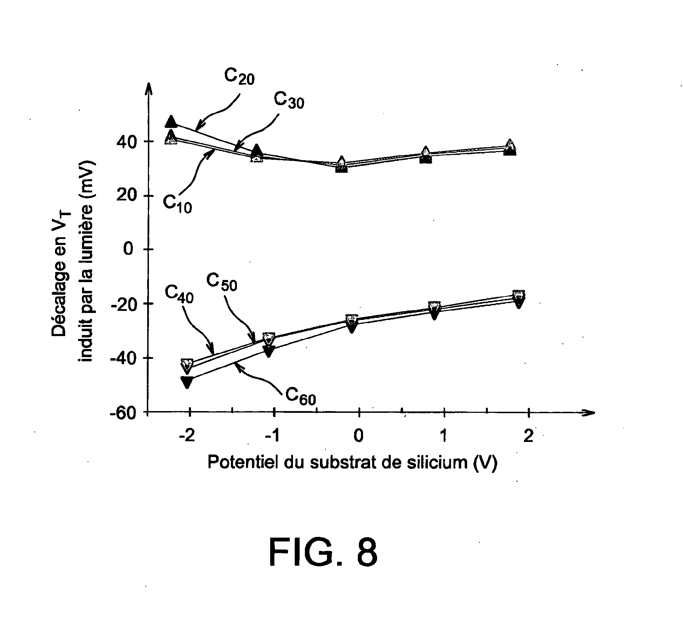

La figure 8 illustre des résultats expérimentaux obtenus sur des transistors de type N et de type P ayant un agencement du type de celui de la figure 2, que l'on a illuminé par la face avant à l'aide d'une lumière blanche polychromatique et dont on a observé l'évolution de la tension de seuil

Les transistors réalisés dans cet exemple comportent une grille de largeur W de 1,2 µm, de longueur L de 20 nm, une épaisseur de la couche semi-conductrice 102 de 6 nm, une épaisseur de la couche isolante 101 de 25 nm. La couche semi-conductrice 205 est en silicium et comporte une jonction N-P, agencée de sorte que la zone N est celle située la plus proche de la couche isolante 101. La zone P de la couche 205 a été obtenue en implantant à travers la couche isolante 101 et avant réalisation du transistor, des ions Bore à une dose de 3*10¹³ cm⁻² et une énergie de 30 keV.

La zone N de la couche 205 a, quant à elle, été obtenue en implantant à travers la couche isolante 101 et avant réalisation du transistor, des ions As à une dose de 4*10¹³ cm⁻² et une énergie comprise entre 70 keV et 95 keV.

Sur la figure 8, les courbes C₁₀, C₂₀, C₃₀ représentent une évolution de la tension de seuil V_{T} du transistor de type N ayant une zone N de la couche semi-conductrice 205 implantée avec de l'Arsenic selon une dose de 4*10¹³ cm⁻² et pour respectivement, une énergie de 70 keV, de 80 keV, et de 95 keV, en fonction d'un potentiel V pris sur la face arrière de la couche semi-conductrice 205.

Les courbes C₄₀, C₅₀, C₆₀ représentent une évolution de la tension de seuil V_{T} du transistor de type P pour respectivement, une zone N de la couche semi-conductrice 205 implantée avec de l'Arsenic selon une dose de 4*10¹³ cm⁻² et respectivement pour une énergie de 70 keV, de 80 keV, et de 95 keV, en fonction d'un potentiel V pris sur la face arrière de la couche 205.

Les courbes C₁₀, C₂₀, C₃₀ de la figure 8 montrent que la tension de seuil du transistor de type N, donc sa caractéristique Id(Vg) (avec Id le courant parcourant le canal et Vg le potentiel de grille) augmente lorsque l'éclairement augmente.

Les courbes C₄₀, C₅₀, C₆₀ montrent que la tension de seuil V_{T} du transistor de type P diminue lorsque l'éclairement augmente.

Le décalage de tension de seuil V_{T} obtenu peut être de l'ordre de 20 mV à 40 mV en valeur absolue et dépend de la polarisation de la face arrière de la couche 205.

En adaptant le couple épaisseur de la couche semi-conductrice 102/épaisseur de la couche isolante 101, un décalage de tension de seuil plus important peut être obtenu.

Pour obtenir une sensibilité de couplage supérieure à 50 mV/V, on peut prévoir par exemple la couche isolante 101 à base de SiO₂ avec une épaisseur de 5 nm, et une couche semi-conductrice 102 avec une épaisseur comprise entre 3 nm à 50 nm, avantageusement entre 3 nm et 25 nm.

Pour une épaisseur de couche isolante 101 de 10 nm, on peut prévoir l'épaisseur de la couche semi-conductrice 102 entre 3 nm et 100 nm, avantageusement comprise entre 3 nm à 50 nm.

Le principe de fonctionnement et les gammes d'épaisseurs mentionnées ci-dessus restent valident pour une zone de canal à base d'un autre matériau semi-conducteur que le silicium, par exemple pour une zone de canal à base de siliciure de germanium.

Le principe de fonctionnement et les gammes d'épaisseurs mentionnées ci-dessus restent valables même lorsque le matériau de la couche isolante 101 n'est pas à base d'oxyde de silicium, mais d'un matériau isolant, tel que par exemple du nitrure de silicium, ou de l'oxyde d'hafnium.

## Revendications

1. Dispositif capteur d'image comprenant au moins un transistor reposant sur un substrat semi-conducteur sur isolant, ledit substrat comprenant :
- une fine couche semi-conductrice (102) dans laquelle une zone de canal dudit transistor est réalisée,
- une couche de support semi-conductrice,
- une couche isolante (101) séparant la fine couche semi-conductrice de la couche de support semi-conductrice,
le dispositif étant **caractérisé en ce que** ladite couche de support semi-conductrice comprend au moins une zone (205) photosensible comportant au moins une région dopée P et au moins une région dopée N formant une jonction disposée en regard de la zone de canal dudit transistor, ladite couche isolante ayant une composition et une épaisseur prévues de manière à permettre un couplage capacitif entre la zone photosensible et la fine couche semi-conductrice.

2. Dispositif selon la revendication 1, dans lequel la jonction est une jonction P-I-N.

3. Dispositif selon l'une des revendications 1 ou 2, dans lequel la couche isolante a une épaisseur inférieure ou égale à 25 nanomètres.

4. Dispositif selon l'une des revendications 1 à 3, dans lequel la fine couche semi-conductrice a une épaisseur inférieure à 800 nm et avantageusement comprise entre 5 nm et 100 nm.

5. Dispositif selon l'une des revendications 1 à 4, dans lequel la zone photosensible a une épaisseur supérieure à 1/a, a étant le coefficient d'absorption linéique du matériau de la zone photosensible.

6. Dispositif selon l'une des revendications 1 à 5, dans lequel la zone photosensible et la fine couche semi-conductrice sont à base de matériaux semi-conducteurs différents.

7. Procédé de réalisation d'un dispositif capteur d'image comprenant des étapes de :
- réalisation d'un transistor (T₁, T₂, T₃, T₄) reposant sur un substrat, le substrat comprenant une couche isolante (101a) et une fine couche semi-conductrice (102) dans laquelle une zone de canal dudit transistor est réalisée,
- assemblage dudit substrat et d'une couche de support semi-conductrice destinée à former une zone (205) de photosensible comprenant une jonction en regard de la zone de canal dudit transistor, ladite couche isolante du substrat ayant une composition et une épaisseur prévues de manière à permettre un couplage capacitif entre la zone photosensible du support et la fine couche semi-conductrice du substrat.

8. Procédé selon la revendication 7, dans lequel l'assemblage est réalisé par collage de la couche isolante avec une autre couche isolante recouvrant ladite couche de support.

9. Procédé selon la revendication 7 ou 8, la jonction étant une jonction PIN.

10. Procédé selon l'une des revendications 7 à 9, dans lequel la zone photosensible et la fine couche semi-conductrice sont à base de matériaux semi-conducteurs différents.

## Patentansprüche

1. Bilderfassungsvorrichtung, umfassend wenigstens einen Transistor, der auf einem Halbleitersubstrat auf einem Isolator ruht, wobei das Substrat umfasst:
- eine dünne Halbleiterschicht (102), in der eine Kanalzone des Transistors realisiert ist,
- eine Halbleiter-Trägerschicht,
- eine Isolierschicht (101), die die dünne Halbleiterschicht von der Halbleiter-Trägerschicht trennt,
wobei die Vorrichtung **dadurch gekennzeichnet ist, dass** die Halbleiter-Trägerschicht wenigstens eine lichtempfindliche Zone (205) umfasst, die wenigstens einen P-dotierten Bereich und wenigstens einen N-dotierten Bereich enthält, die einen Übergang bilden, welcher gegenüber der Kanalzone des Transistors angeordnet ist, wobei die Isolierschicht eine Zusammensetzung und eine Dicke hat, die derart gewählt sind, dass eine kapazitive Kopplung zwischen der lichtempfindlichen Zone und der dünnen Halbleiterschicht ermöglicht wird.

2. Vorrichtung nach Anspruch 1, bei der der Übergang ein P-I-N-Übergang ist.

3. Vorrichtung nach einem der Ansprüche 1 oder 2, bei der die Isolierschicht eine Dicke kleiner oder gleich 25 Nanometern hat.

4. Vorrichtung nach einem der Ansprüche 1 bis 3, bei der die dünne Halbleiterschicht eine Dicke von weniger als 800 nm hat, und vorzugsweise zwischen 5 nm und 100 nm.

5. Vorrichtung nach einem der Ansprüche 1 bis 4, bei der die lichtempfindliche Zone eine Dicke größer als 1/a hat, wobei a der lineare Absorptionskoeffizient des Materials der lichtempfindlichen Zone ist.

6. Vorrichtung nach einem der Ansprüche 1 bis 5, bei der die lichtempfindliche Zone und die dünne Halbleiterschicht auf Grundlage von verschiedenen Halbleitermaterialien hergestellt sind.

7. Verfahren zur Herstellung einer Bilderfassungsvorrichtung, umfassend die folgenden Schritte:
- Herstellen eines Transistors (T₁, T₂, T₃, T₄) der auf einem Substrat ruht, wobei das Substrat eine Isolierschicht (101 a) sowie eine dünne Halbleiterschicht (102) umfasst, in der eine Kanalzone des Transistors realisiert ist,
- Zusammenfügen des Substrats und einer Halbleiter-Trägerschicht, die dazu ausgelegt ist, eine lichtempfindliche Zone (205) zu bilden, umfassend einen Übergang gegenüber der Kanalzone des Transistors, wobei die Isolierschicht des Substrats eine Zusammensetzung und eine Dicke hat, die derart gewählt sind, dass eine kapazitive Kopplung zwischen der lichtempfindlichen Zone des Trägers und der dünnen Halbleiterschicht des Substrats ermöglicht wird.

8. Verfahren nach Anspruch 7, bei der das Zusammenfügen realisiert wird durch Verkleben der Isolierschicht mit einer anderen Isolierschicht, welche die Trägerschicht bedeckt.

9. Verfahren nach Anspruch 7 oder 8, wobei der Übergang ein PIN-Übergang ist.

10. Verfahren nach einem der Ansprüche 7 bis 9, bei der die lichtempfindliche Zone und die dünne Halbleiterschicht auf Grundlage von unterschiedlichen Halbleitermaterialien hergestellt sind.

## Claims

1. An image sensor device comprising at least one transistor lying on a semiconductor-on-insulator substrate, the substrate comprising:
- a thin semi-conducting layer (102) wherein a channel area of said transistor is made,
- a semi-conducting support layer,
- an insulating layer separating the thin semi-conducting layer from the semi-conducting support layer, the device being **characterized in that** the semi-conducting support layer comprises at least one photosensitive area (205) including at least one P-doped region and at least one N-doped region forming a junction provided facing the channel area of said transistor, the insulating layer having a composition and a thickness set so as to provide a capacitive coupling between the photosensitive area and the thin semi-conducting layer.

2. The device according to claim 1, wherein the junction is a P-I-N junction.

3. The device according to any of claims 1 or 2, wherein the insulating layer has a thickness equal to or less than 25 nanometers.

4. The device according to any of the claims 1 to 3, wherein the thin semi-conducting layer has a thickness of less than 800 nm and advantageously between 5 nm and 100 nm.

5. The device according to any of the claims 1 to 4, wherein the photosensitive area has a thickness higher than 1/a, a being the linear absorption coefficient of the material of the photosensitive area.

6. The device according to any of the claims 1 to 5, wherein the photosensitive area and the thin semi-conducting layer are based on different semiconductor materials.

7. A method for making an image sensor device including the steps of:
- making a transistor (T₁, T₂, T₃, T₄) lying on a substrate, the substrate comprising an insulating layer (101a) and a thin semi-conducting layer (102) wherein a channel area of said transistor is made,
- assembling said substrate and a semi-conducting support layer for forming a photosensitive area comprising a junction facing the channel area of said transistor, the insulating layer having a composition and a thickness set so as to provide a capacitive coupling between the photosensitive area of said support and the thin semi-conducting layer of said substrate.

8. The method according to claim 7, wherein the assembling is made by bonding the insulating layer with another insulating layer covering said support layer.

9. The method according to claim 7 or 8, wherein the junction is a PIN junction.

10. The method according to any of the claims 7 to 9, wherein the photosensitive area and the thin semi-conducting layer are based on different semiconductor materials.
